# EUROPÄISCHE PATENTSCHRIFT

(11) **EP 2 264 479 B1**
(45) Veröffentlichungstag und Bekanntmachung des Hinweises auf die Patenterteilung: **09.09.2015**
(21) Anmeldenummer: 10006007.8
(22) Anmeldetag: 10.06.2010
(51) Int. Cl.: G01S 7/292, G01R 23/16, G01S 7/295

(54) **Verfahren und Vorrichtung zur ereignisgestützten Reduktion des Zeit-Frequenz-Bereichs eines Signals**
Method and device for result-supported reduction of the time-frequency range of a signal
Procédé de fabrication d'une fermeture de récipient

(30) Priorität: 18.06.2009 DE 102009025369; 03.08.2009 DE 102009035944
(43) Veröffentlichungstag der Anmeldung: 22.12.2010
(73) Patentinhaber: Rohde & Schwarz GmbH & Co. KG, 81671 München (DE)
(72) Erfinder: Robelly, Pablo, Dr., Quito (EC)
(74) Vertreter: Körfer, Thomas

(56) Entgegenhaltungen:
- US-A1- 2006 265 218
- US-A1- 2008 101 626

## Beschreibung

Die Erfindung betrifft ein Verfahren und eine Vorrichtung zur ereignisgestützten Reduktion des Zeit-Frequenz-Bereichs eines Signals.

In der Radartechnik sind in Echtzeit die in einem breitbandigen, üblicherweise verrauschten Empfangssignal enthaltenen Radarsignale zu detektieren. Hierbei handelt es sich typischerweise um periodische Pulssignale oder um periodische Analogsignale (Continuous-wave-Signale, CW-Signale) mit einer begrenzten Signallänge. Diese Radarsignale können darüberhinaus mit einem bestimmten Modulationsverfahren, beispielsweise QPSK, moduliert sein und als Einträger- oder als Mehrträgersignal, beispielsweise als OFDM-Signal, übertragen werden.

Aus der DE 10 2005 025 402 A1 geht ein Verfahren zur zweistufigen Klassifizierung eines Empfangssignals im Zeit- und Frequenzbereich hervor. Aufgrund der hohen Bandbreite des Empfangssignal und der für die Detektion des Radarsignals erforderlichen langen Detektionsdauer ist in Echtzeit eine hohe Anzahl von Signaldaten zu speichern und zu verarbeiten. Mit den herkömmlichen Prozessorleistungen kommt man hierbei an die Leistungsgrenze.

Weitere einschlägige Verfahren sind aus US2008/0101626 A1 und US2006/02652218 A1 bekannt.

Aufgabe der Erfindung ist es deshalb, ein Verfahren und eine Vorrichtung zur Detektion eines Radarsignals in einem breitbandigen Empfangssignal zu entwickeln, das eine Signalverarbeitung in Echtzeit ermöglicht.

Die Erfindungsaufgabe wird durch ein Verfahren mit den Merkmalen des Patentanspruchs 1 und durch eine Vorrichtung mit den Merkmalen des Patentanspruchs 9 gelöst. Vorteilhafte technische Weiterbildungen der Erfindung sind in den abhängigen Patentansprüchen aufgeführt.

Erfindungsgemäß wird ein Spektrogramm des Eingangssignals mittels einer Analysefilterbank, beispielsweise mit einer Fourier-Transformation, ermittelt. Aus dem Spektrogramm des Eingangssignals in voller Bandbreite werden über einen bestimmten Detektionszeitraum anhand von bestimmten Kriterien Unterfrequenzbereiche und Unterzeitbereiche des Spektrogramms selektiert und mittels einer Synthesefilterbank, bevorzugt mit einer inversen Fourier-Transformation, in ein zugehöriges Ausgangssignal transformiert.

Als Kriterien können beispielsweise bestimmte Ereignisse im Spektrogramm herangezogen werden. So können beispielsweise diejenigen Unterfrequenzbereiche des Spektrogramms selektiert werden, in denen das Signal eine bestimmte Mindestsignalenergie oder einen bestimmten Signal-Rausch-Abstand aufweist. Unterfrequenzbereiche, in denen nur Rauschen, aber kein Nutzsignalinhalt identifiziert wird, werden nach der Selektion für die Detektion des Radarsignals nicht mehr weiter berücksichtigt. Daneben können bestimmte Unterfrequenzbereiche, die Störspektralanteile enthalten, von der Selektion ausgeschlossen werden. Hierzu werden bevorzugt typische Spektralverläufe von Störsignalen in der Zeit-Frequenz-Ebene in Abgrenzung zu typischen Spektralverläufen von Nutzsignalen in der Zeit-Frequenz-Ebene beispielsweise über Referenzmuster identifiziert.

Neben derartigen Ereignissen im Spektrogramm des Eingangssignals können vorzugsweise für die Selektion von Unterfrequenzbereichen und/oder Unterzeitbereichen innerhalb des Detektionszeitraums auch Ereignisse im Eingangs- und/oder Ausgangssignals im Zeitbereich herangezogen werden. Wird im Zeitbereich im Eingangs- und/oder Ausgangssignal beispielsweise eine Periodizität mit einer bestimmten Frequenz identifiziert, so wird ein Unterfrequenzbereich des Spektrogramms, der die Frequenz der Periodizität enthält, selektiert. Weist das Eingangs- und/oder Ausgangssignal innerhalb eines Detektionszeitraums Unterzeitbereiche mit einem aktivierten Eingangs- bzw. Ausgangssignal und Unterzeitbereiche mit einem deaktivierten Eingangs- bzw. Ausgangssignal auf, so werden lediglich die Unterzeitbereiche des Spektrogramms mit aktivierten Eingangs- bzw. Ausgangssignals selektiert. Schließlich können als Ereignisse im Eingangs- und/oder Ausgangssignal auch andere Klassifizierungen benutzt werde, beispielsweise das Vorliegen einer bestimmten Modulation, beispielsweise einer QPSK-Modulation, oder das Vorliegen eines OFDM- oder CDMA-Signals.

Zusätzlich kann auch ein externes, nicht im Empfangssignal liegendes Ereignis, beispielsweise eine Information, dass das zu detektierende Radarsignal nur in einem bestimmten Frequenzabschnitt übertragen wird, in die Selektion der Unterfrequenzbereiche des Spektrogramms eingehen.

Für die Selektion von Unterfrequenzbereichen und Unterzeitbereichen des Spektrogramms können vorzugsweise mehrere Ereignisse miteinander logisch verknüpft werden. Beispielsweise kann als erstes Ereignis eine Periodizität des Eingangs- und/oder Ausgangssignals und als zweites Ereignis ein Pulssignal logisch miteinander verknüpft werden, falls das Radarsignal ein periodisches Pulssignal ist.

Vorzugsweise werden als Unterfrequenzbereiche des zu untersuchenden Spektrogramms die Frequenzbereiche von parallel arbeitenden Analysefilterbanken, beispielsweise von parallel arbeitenden Fast-Fourier-Transformatoren benutzt, die jeweils das Spektrogramm in einem bestimmten Unterfrequenzbereich der vollständigen Bandbreite erzeugen.

Schließlich sind bevorzugt vor der tatsächlichen Selektion der einzelnen Unterfrequenzbereiche und Unterzeitbereiche des Spektrogramms noch bestimmte Kriterien hinsichtlich der physikalischen und systemtheoretischen Korrektheit des aus den selektierten Unterfrequenzbereichen und/oder Unterzeitbereichen mittels einer Synthesefilterbank, beispielsweise mittels einer inversen Fourier-Transformation, gewonnenen Ausgangssignals zu überprüfen. Beispielsweise ist im Sinne des systemtheoretischen Reziprozitätsgesetzes zwischen Bandbreite und Zeitdauer die gesamte Bandbreite über alle selektierten Unterfrequenzbereiche so groß zu wählen, dass das mittels einer Synthesefilterbank, beispielsweise einer inversen Fourier-Transformation, gewonnene Ausgangssignal eine Zeitdauer aufweist, in der die für die Detektion des Radarsignals relevanten Signalanteile vorhanden sind.

Das erfindungsgemäße Verfahren und die erfindungsgemäße Vorrichtung zur ereignisgestützten Reduktion des Zeit-Frequenz-Bereichs eines Signals werden im Folgenden anhand der Zeichnung erläutert. Die Figuren der Zeichnung zeigen:
- Fig. 1: ein Blockdiagramm eines Ausführungsbeispiels der erfindungsgemäßen Vorrichtung zur ereignisgestützten Reduktion des Zeit-Frequenz-Bereichs eines Signals und
- Fig. 2: ein Flussdiagramm eines Ausführungsbeispiels des erfindungsgemäßen Verfahrens zur ereignisgestützten Reduktion des Zeit-Frequenz-Bereichs eines Signals.

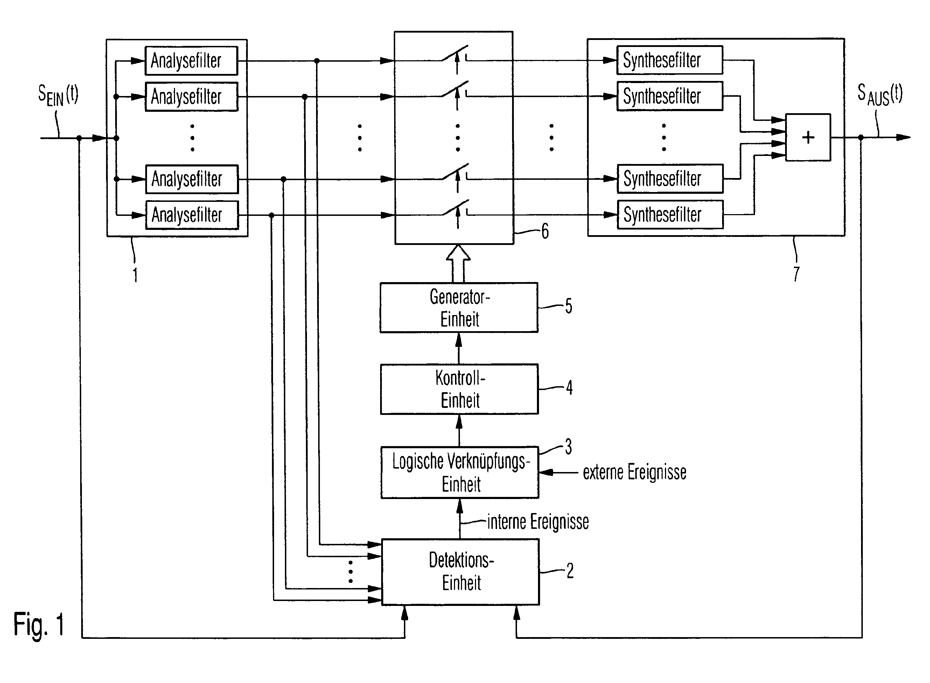

In der erfindungsgemäßen Vorrichtung zur ereignisgestützten Reduktion des Zeit-Frequenz-Bereichs eines Signals gemäß Fig. 1 wird ein Eingangssignal *s_{EN}*(*t*) sukzessive in zyklischen Zeitpunkten einer Analysefilterbank 1, beispielsweise einem Fast-Fourier-Transformator 1, zugeführt, der das Fourierspektrum des Eingangssignals *s_{EIN}*(*t*) zu den einzelnen zyklischen Zeitpunkten und somit ein Spektrogramm des Eingangssignals *s_{EIN}*(*t*) ermittelt. Die Ermittlung des Spektrogramms des Eingangssignals *s_{EIN}*(*t*) erfolgt quasi-kontinuierlich in Echtzeit. Bei der Analysefilterbank 1, beispielsweise beim Fast-Fourier-Transformator 1, handelt es sich insbesondere um eine bestimmte Anzahl parallel arbeitender Analysefiltern der Analysefilterbank, beispielsweise um Fast-Fourier-Transformatoren, die das gesamte Spektrogramm des Eingangssignals *s_{EIN}*(*t*) in jeweils einem zugeordneten Unterfrequenzbereich ermitteln. Bei den einzelnen Unterfrequenzbereichen handelt es sich dabei um einzelne Kanäle, die z.B. die FFT-Bins des jeweiligen Fast-Fourier-Transformators umfassen.

Das sukzessive ermittelte Spektrogramm des Eingangssignals *s_{EIN}*(*t*) wird in einem in Fig. 1 nicht dargestellten Zwischenpuffer zwischengespeichert. Für eine Detektion von internen Ereignissen im Spektrogramm des Eingangssignals *s_{EIN}*(*t*) wird zyklisch jeweils ein Zeitabschnitt des Spektrogramms von der Dauer eines Detektionsintervalls herangezogen, das mindestens der Länge eines typischen Radarsignals entspricht. Das Spektrogramm des Eingangssignals *s_{EIN}*(*t*) im jeweiligen Detektionsintervall wird einer Detektions-Einheit 2 zugeführt.

Neben dem Spektrogramm des Eingangssignals *s_{EIN}*(*t*) im jeweiligen Detektionsintervall wird auch das Eingangssignal *s_{EIN}*(*t*) und das Ausgangssignal *s_{AUS}*(*t*) im jeweiligen Detektionsintervall der Detektions-Einheit 2 zugeführt. In der Detektions-Einheit 2 werden interne Ereignisse im Spektrogramm des Eingangssignals *s_{EIN}*(*t*), im Eingangssignal *s_{EIN}*(*t)* und im Ausgangssignal *s_{AUS}*(*t*) innerhalb des jeweiligen Detektionsintervalls gesucht.

Im Fall des Spektrogramms des Eingangssignals *s_{EIN}*(*t*) werden Unterfrequenzbereiche identifiziert, in denen für die Detektion des Radarsignals keine relevanten Spektralanteile enthalten sind. Dies sind insbesondere Unterfrequenzbereiche, in denen mit Ausnahme eines Grundrauschen oder eines vernachlässigbaren Rauschteppichs keine Spektralanteile auftreten oder in denen offenkundig keine Spektralanteile von Nutzsignalen, sondern lediglich Spektralanteile von Störsignalen vorhanden sind. Während Unterfrequenzbereiche ohne wesentliche Spektralanteile durch Ermittlung der Signalenergie oder des Signal-Rausch-Abstands in den einzelnen Unterfrequenzbereichen und durch anschließenden Vergleich der gemessenen Signalenergie oder des ermittelten Signal-Rausch-Abstands mit einem vorher definierten Schwellwert erfolgt, können Unterfrequenzbereiche mit Störsignalanteilen anhand von für Störsignale charakteristischen Referenz-Spektralverläufen in der Zeit-Frequenz-Ebene identifiziert werden.

Im Fall des Eingangssignals *s_{EIN}*(*t*) und des Ausgangssignals *s_{AUS}*(*t*) werden Unterzeitbereiche identifiziert, in denen das Eingangssignal *s_{EIN}*(*t*) und/oder das Ausgangssignal *s_{AUS}*(*t*) nicht aktiviert ist und somit die Signalenergie oder der Signalrausch-Abstand unterhalb eines vorher definierten Schwellwert liegt.

Daneben werden Periodizitäten einer bestimmten Frequenz im Eingangssignal *s_{EIN}*(*t*) und/oder im Ausgangssignal *s_{AUS}*(*t*) identifiziert werden. Bei Vorliegen von Periodizitäten im Eingangssignal *s_{EIN}*(*t*) und im Ausgangssignal *s_{AUS}*(*t*) werden anschließend diejenigen Unterfrequenzbereiche des Spektrogramms selektiert, in denen die Frequenzen der selektierten Periodizitäten liegen, während die übrigen Unterfrequenzbereiche des Spektrogramms nicht weiter berücksichtigt werden. Außerdem werden innerhalb der selektierten Unterfrequenzbereiche des Spektrogramms nur diejenigen Unterzeitbereiche des Spektrogramms selektiert, in denen die Periodizitäten aktiv sind.

Schließlich werden im Eingangssignal *s_{EIN}*(*t*) und/oder im Ausgangssignal *s_{AUS}*(*t*) mit herkömmlichen zeitbereichsorientierten Verfahren Frequenzen von Störsignalanteilen ermittelt und die Unterfrequenzbereiche des Spektrogramms, in denen die ermittelten Frequenzen der Störsignalanteile liegen, nicht weiter berücksichtigt.

Alle von der Detektions-Einheit 2 identifizierten Detektionsergebnisse werden als interne Ereignisse einer der Detektions-Einheit 2 nachgeschalteten logischen Verknüpfungs-Einheit 3 zugeführt. Der logischen Verknüpfungs-Einheit 3 wird zusätzlich ein extern identifiziertes Ereignis, beispielsweise das dem Anwender bekannte Wissen, dass das Radarsignal in bestimmten Unterfrequenzbereichen überhaupt nicht zu suchen ist, zugeleitet. Die logische Verknüpfung-Einheit 3 verknüpft mehrere interne Ereignisse und eventuell auch mehrere externe Ereignisse zur Gewinnung eines Ereignisses, das bei gleichzeitigem Vorliegen mehrerer Ereignisse auftritt, logisch miteinander. Die logische Verknüpfungs-Einheit 2 detektiert beispielsweise das Ereignis des Vorliegens eines periodischen Pulssignals, indem sie die Detektion einer Periodizität im Eingangssignal *s_{EIN}*(*t*) und/oder im Ausgangssignal *s_{AUS}*(*t*) durch die Detektions-Einheit 2 und die Detektion eines Pulssignals im Eingangssignal *s_{EIN}*(*t*) und/oder im Ausgangssignal *s_{AUS}*(*t*) durch die Detektions-Einheit 2 logisch UND-verknüpft.

Der logischen Verknüpfungs-Einheit 3 folgt eine Kontroll-Einheit 4, die überprüft, ob das entsprechend der detektierten Ereignisse aus den selektierten Unterfrequenzbereichen und den selektierten Unterzeitbereichen gewonnene Ausgangssignal *s_{AUS}*(*t*) ein physikalisch und/oder systemtheoretisch korrektes Signal darstellt. Ist dies nicht der Fall, so ist die Selektion der Unterfrequenzbereiche und der Unterzeitbereiche des aus dem Eingangssignal *s_{EIN}*(*t*) gewonnenen Spektrogramms soweit zu modifizieren, bis die physikalische und/oder systemtheoretische Korrektheit des zu ermittelnden Ausgangssignals *s_{AUS}*(*t*) gegeben ist.

Im Anschluss an die Kontroll-Einheit 5 ist eine Generator-Einheit 5 geschaltet, die in Abhängigkeit der detektierten Ereignisse Selektierungssignale zur Selektierung der einzelnen Unterfrequenzbereiche und Unterzeitbereiche im Spektrogramm des Eingangssignals *s_{EIN}*(*t*) in der Selektions-Einheit 6 generiert. Bei den Selektierungssignalen handelt es sich um Ansteuersignale für einzelne Schalter in der Selektions-Einheit 6, die einzelne Unterfrequenzbereiche des Spektrogramms des Eingangssignals *s_{EIN}*(*t*) während der einzelnen selektierten Unterzeitbereiche durchschalten und somit selektieren.

Die Selektions-Einheit 6 schaltet die einzelnen Spektren, die von jeweils einer parallel arbeitenden Analysefilter der gesamten Analysefilterbank 1, beispielsweise von jeweils einem parallel arbeitenden Fast-Fourier-Transformator des gesamten Fast-Fourier-Transformators 1, ermittelt werden und jeweils einen Unterfrequenzbereich bilden, über intern realisierte Schalter entsprechend der Aktivierung der zu den einzelnen Unterfrequenzbereichen gehörigen Selektierungssignale. Die zu einer Teil-Analysefilterbank der gesamten Analysefilterbank 1, z.B. zu einem Fast-Fourier-Transformator des gesamten Fast-Fourier-Transformator 1, gehörigen Spektren sind in Fig. 1 jeweils als eine einzelne Linie dargestellt und werden jeweils einem der Eingänge der Selektions-Einheit 6 zugeführt. Die Selektierung der einzelnen Unterzeitbereiche innerhalb der selektierten Unterfrequenzbereiche des Spektrogramms des Eingangssignals *s_{EIN}*(*t*) erfolgt äquivalent durch Aktivierung der zugehörigen internen Schalter der Selektions-Einheit 6 während der Dauer des einzelnen Unterzeitbereichs.

Die selektierten bzw. nicht selektierten Unterfrequenzbereiche des Spektrogramms des Eingangssignals *s_{EIN}*(*t*) werden an dem jeweils zugehörigen Ausgang der Selektions-Einheit 6 einer Synthesefilterbank 7, beispielsweise einem inversen Fast-Fourier-Transformator 7, zugeführt, der mittels Signalsynthese, z.B. mittels inverser Fourier-Transformation, aus den selektierten Unterfrequenzbereichen und den selektierten Unterzeitbereichen des Spektrogramms des Eingangssignals *s_{EIN}*(*t*) das Ausgangssignal *s_{AUS}*(*t*) erzeugt. Die Synthesefilterbank 7, z.B. der inverse Fast-Fourier-Transformator 7, ist in Analogie zur Analysefilterbank 1, aus einer identischen Anzahl von parallel arbeitenden Synthesefiltern, beispielsweise von parallel arbeitenden inversen Fast-Fourier-Transformatoren aufgebaut, die jeweils für einen Unterfrequenzbereich des Spektrogramms des Eingangssignals *s_{EIN}*(*t*) das zugehörige Ausgangssignal generieren. Die Ausgangssignale der einzelnen Synthesefilter, z.B. der inversen Fast-Fourier-Transformatoren, innerhalb der gesamten Synthesefilterbank 7, werden zur Bildung des Ausgangssignals *s_{AUS}*(*t*) einem in der gesamten Synthesefilterbank 7, integrierten Summationsglied zugeführt.

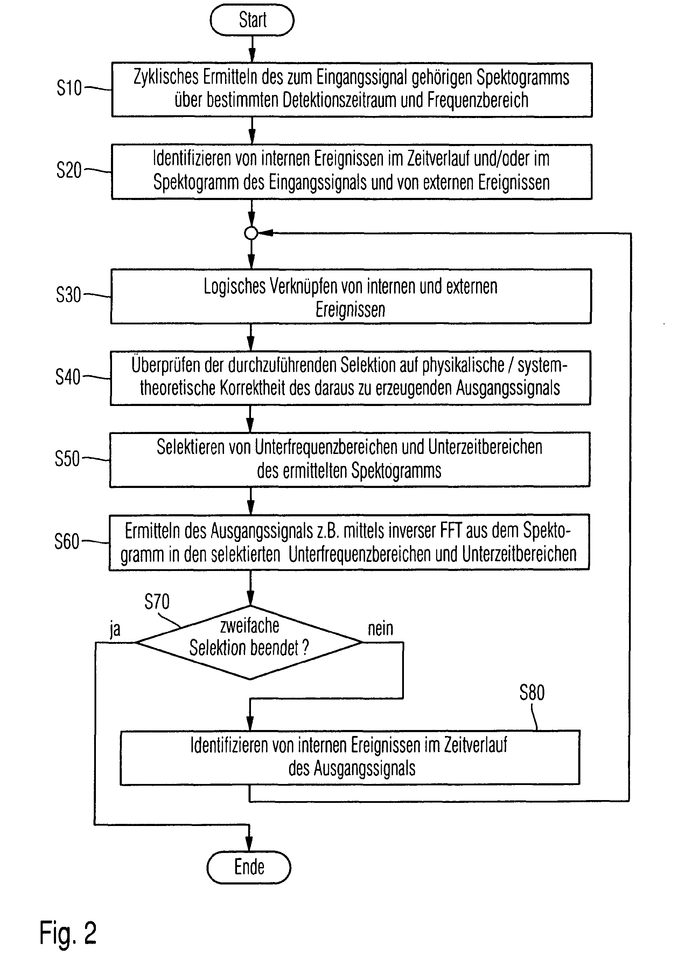

Das erfindungsgemäße Verfahren zur ereignisgestützten Reduktion des Zeit-Frequenz-Bereichs eines Signals beginnt gemäß dem Flussdiagramm in Fig. 2 im ersten Verfahrensschritt S10 mit dem zyklischen Ermitteln des zum Eingangssignal *s_{EIN}*(*t*) gehörigen Spektrogramms in Echtzeit. Der Zyklus der Ermittlung des zum Eingangssignal *s_{EIN}*(*t*) gehörigen Spektrogramms erstreckt sich jeweils über ein Detektionsintervall. Dieses Detektionsintervall ist mindestens so bemessen, dass jedes im Empfangssignal enthaltene Radarsignal über seine volle Signallänge im Detektionsintervall enthalten ist. Die Länge des Detektionsintervall ist nach oben durch die Leistungsfähigkeit der verwendeten Analysefilter, z.B. der Fast-Fourier-Transformatoren (schnelle Fourier Transformation FFT), und der Synthesefilter, z.B. der inversen Fast-Fourier-Transformatoren, begrenzt. Für die Fast-Fourier-Transformationen werden gängige Fast-Fourier-Transformations-Algorithmen verwendet. Durch die Parallelisierung der Analysebankfilterung bzw. der Fast-Fourier-Transformation auf mehrere nebengeordnete Analysefilter bzw. Fast-Fourier-Transformatoren, die jeweils für einen Unterfrequenzbereich des vollständigen Frequenzbereichs zuständig sind, kann die sehr rechenaufwendige Analysebankfilterung bzw. Fast-Fourier-Transformation über eine hohe Bandbreite in Echtzeit mit derzeit realisierbaren Architekturen in FPGA-Technologie überhaupt erst verwirklicht werden. Im Zyklus des zyklische Einlesens des Eingangssignals *s_{EIN}*(*t*) über jeweils ein Detektionsintervall wird das im jeweiligen Unterfrequenzbereich generierte Spektrogramm des Eingangssignals in einem in Fig. 1 nicht dargestellten Zwischenspeicher zwischengepuffert.

Im nächsten Verfahrensschritt S20 werden interne Ereignisse in den einzelnen Unterfrequenzbereichen des über jeweils ein Detektionsintervall ermittelten Spektrogramms des Eingangssignals *s_{EIN}*(*t*) und in jeweils einem Detektionsintervall des Zeitverlaufs des Eingangssignals *s_{EIN}*(*t*) identifiziert. Daneben werden auch externe, nicht im Signalverlauf bzw. im Spektrogramm des Eingangssignals *s_{EIN}*(*t*) enthaltene Ereignisse identifiziert. Bei den internen Ereignissen kann es sich um folgende, nicht vollständige Aufzählung von Typen von technisch detektierbaren und klassifizierbaren Signalereignissen handeln:
- Signalklasse (analoge Signale, gepulste Signale),
- Signalperiodizität (periodische Signale, a-periodische Signale),
- verwendete Modulation (16QAM, QPSK, usw.)
- verwendeter Träger (Mehrträgersignal, Einträgersignal),
- verwendetes Multiplexverfahren (CDMA, TDMA, FDMA, SDMA),
- verwendeter Funk- bzw. Mobilfunkstandard und
- verwendetes Frequenzband im Funk bzw. Mobilfunk.

Im nächsten Verfahrensschritt S30 erfolgt die logische Verknüpfung von mehreren detektierten Ereignissen, die gleichzeitig im Spektrogramm des Eingangssignals *s_{EIN}*(*t*) bzw. im Zeitverlauf des Eingangssignals *s_{EIN}*(*t*) während des jeweiligen Detektionsintervalls auftreten, um ein komplexeres Ereignis zu detektieren, beispielsweise die Detektion eines periodischen, mit einem bestimmten digitalen Modulationsverfahren modulierten Pulssignals in einem bestimmten Frequenzband.

Steht das endgültige Ereignis oder stehen mehrere endgültigen Ereignisse und somit auch die zum Ereignis bzw. zu den Ereignissen gehörigen, zu selektierenden Unterfrequenzbereiche und/oder Unterzeitbereiches des Spektrogramms des Eingangssignals *s_{EIN}*(*t*) fest, so wird im nächsten Verfahrensschritt S40, bevor die eigentliche Selektion durchgeführt wird, vorab überprüft, ob das aus den selektierten Unterfrequenzbereichen und/oder Unterzeitbereichen ermittelte Ausgangssignal *s_{AUS}*(*t*) ein physikalisch und/oder systemtheoretisch korrektes bzw. technisch realisierbares Signal ist. Hierfür können eine Reihe von systemtheoretischen Kriterien, beispielsweise das Reziprozitätgesetz zwischen Bandbreite und Zeitintervall eines Signals oder das Nyquist-Kriterium, herangezogen werden. Bei Nichterfüllung mindestens eines dieser systemtheoretischen Kriterien ist die Selektion der Unterfrequenzbereiche und/oder der Unterzeitbereiche entsprechend soweit zu modifizieren, bis eine physikalische und systemtheoretische Korrektheit des Ausgangssignals *s_{AUS}*(*t*) gewährleistet ist.

Die zu selektierenden Unterfrequenzbereiche und Unterzeitbereiche des Spektrogramms des Eingangssignals *s_{EIN}*(*t*) werden im nächsten Verfahrensschritt S50 mittels zu generierender Selektierungssignale, die auf der Basis der detektierten endgültigen Ereignisse erzeugt werden, durchgeführt. Die Selektionsergebnisse werden in einem in Fig. 1 nicht dargestellten Zwischenspeicher zwischengepuffert.

Aus den selektierten Unterfrequenzbereichen und/oder den selektierten Unterzeitbereichen des Spektrogramms des Eingangssignals *s_{EIN}*(*t*) wird im nächsten Verfahrensschritt S60 z.B. mittels inverser Fast-Fourier-Transformation das Ausgangssignal *s_{AUS}*(*t*) ermittelt. Hierbei sind nur diejenigen der parallel arbeitenden Synthesefiltern bzw. inversen Fast-Fourier-Transformatoren der gesamten Synthesefilterbank bzw. des gesamten inversen Fast-Fourier-Transformators aktiv, die jeweils einen selektierten Unterfrequenzbereich des Spektrogramms des Eingangssignals *s_{EIN}*(*t*) in ein korrespondierendes Ausgangssignal im Zeitbereich transformieren.

Im nächsten Verfahrensschritt S70 erfolgt eine Abfrage, ob eine zweifache Selektion bereits durchgeführt ist. Wurde die zweifache Selektion bereits durchgeführt, so ist das erfindungsgemäße Verfahren bereits beendet. Im Fall, dass erst eine einzige Selektion durchgeführt wurde, werden im nächsten Verfahrensschritt S80 im Ausgangssignal *s_{AUS}*(*t*) interne Ereignisse in äquivalenter Weise wie beim Eingangssignal *s_{EIN}*(*t*) in Verfahrensschritt S20 identifiziert. Im Anschluss daran werden wie im Fall der Detektion von internen Ereignissen im Eingangssignal *s_{EIN}*(*t*) die Verfahrensschritte des logischen Verknüpfens von internen und externen Ereignissen gemäß Verfahrensschritt S30, des Überprüfens der physikalischen und systemtheoretischen Korrektheit des aus dem Selektionsergebnis erzeugten Ausgangssignal *s_{AUS}*(*t*) gemäß Verfahrensschritt S40, des Selektierens der Unterfrequenzbereiche und der Unterzeitbereiche des Spektrogramms des Eingangssignals *s_{EIN}*(*t*) gemäß Gleichung S50 und des Ermittelns des Ausgangssignals *s_{AUS}*(*t*) aus den selektierten Unterfrequenzbereichen und aus den selektierten Unterzeitbereichen des Spektrogramms des Eingangssignals *s_{EIN}*(*t*) gemäß Verfahrensschritt S60 durchgeführt.

Die Erfindung ist nicht auf die dargestellte Ausführungsform des erfindungsgemäßen Verfahrens und der erfindungsgemäßen Vorrichtung zur ereignisgestützten Reduktion des Zeit-Frequenz-Bereichs eines Signals beschränkt. Die Verwendung von Fourier-Transformatoren für die Analysefilterbank und von inversen Fourier-Transformatoren für die Synthesefilterbank ist nur eines mehrerer denkbarer Beispiele. Von der Erfindung ist insbesondere die Selektion von Unterfrequenzbereichen und/oder von Unterzeitbereichen des Spektrogramms anhand von spezifischen Frequenz-Zeit-Referenzmustern im Sinne einer Frequency-Mask-Triggerung (Frequenz-Markierungs-Triggerung) abgedeckt.

## Patentansprüche

1. Verfahren zur Generierung eines gegenüber einem Eingangssignal (*s_{EIN}*(*t*)) im Zeitbereich und gleichzeitig im Frequenzbereich reduzierten zwischengespeicherten Ausgangssignals (*s_{AUS}*(*t*)) mit
folgenden Verfahrensschritten:
• Ermitteln eines Spektrogramms des Eingangssignals (*s_{EIN}*(*t*)) in einem bestimmten Zeit-Frequenz-Bereich,
• Selektieren des Spektrogramms des Eingangssignals (*s_{EIN}*(*t*)) in mindestens einem Unterfrequenzbereich und/oder Unterzeitbereich des Zeit-Frequenz-Bereichs und Nicht-Weiterberücksichtigen der übrigen Unterfrequenzbereiche und/oder Unterzeitbereiche des Zeit-Frequenz-Bereichs,
• Ermitteln des Ausgangssignals (*s_{AUS}*(*t*)) einzig aus dem selektierten Spektrogramm,
wobei für die Selektion der Unterfrequenzbereiche und/oder der Unterzeitbereiche Ereignisse im Spektrum des Eingangssignals (*s_{EIN}*(*t*)) und/oder im Zeitbereich des Eingangssignals (*s_{EIN}*(*t*)) und/oder des Ausgangssignals *(s_{AUS}(t*)) detektiert werden,
**dadurch gekennzeichnet,**
**dass** die Selektion der Unterfrequenzbereiche und/oder der Unterzeitbereiche mittels zu generierender Selektierungssignale in Abhängigkeit der detektierten Ereignisse soweit modifiziert wird, dass für das ermittelte Ausgangssignal (*s_{AUS}*(*t*)) das Reziprozitätsgesetz der Nachrichtentechnik und das Nyquist-Kriterium zusätzlich erfüllt sind.

2. Verfahren nach Anspruch 1,
**dadurch gekennzeichnet,**
**dass** die Selektion von mindestens einem Unterfrequenzbereich und/oder einem Unterzeitbereich im Spektrogramm des Eingangssignals (*s_{EIN}*(*t*)) auf der Basis von mindestens einem vorher festgelegten Ereignis in einzelnen Zeit-Frequenzrasterpunkten des Eingangssignals (*s_{EIN}*(*t*)) erfolgt.

3. Verfahren nach Anspruch 1 oder 2,
**dadurch gekennzeichnet,**
**dass** die Selektion von mindestens einem Unterfrequenzbereich und/oder einem Unterzeitbereich im Spektrogramm des Eingangssignals *(s_{EIN}*(*t*)) auf der Basis von mindestens einem vorher festgelegten Ereignis in einzelnen Zeitrasterpunkten des Eingangssignals (*s_{EIN}*(*t*)) und/oder des Ausgangssignals (*s_{AUS}*(*t*)) erfolgt.

4. Verfahren nach einem der Ansprüche 1 bis 3,
**dadurch gekennzeichnet,**
**dass** die Selektion von mindestens einem Unterfrequenzbereich und/oder einem Unterzeitbereich im Spektrogramm des Eingangssignals (*s_{EIN}*(*t*)) auf der Basis eines extern eingetretenen Ereignisses erfolgt.

5. Verfahren nach einem der Ansprüche 2 bis 4,
**dadurch gekennzeichnet,**
**dass** das Ereignis eine Periodizität Eingangssignal (*s_{EIN}*(*t*)) und/oder im Ausgangssignal (*s_{AUS}*(*t*)) ist.

6. Verfahren nach einem der Ansprüche 2 bis 4,
**dadurch gekennzeichnet,**
**dass** das Ereignis das Vorliegen einer bestimmten Signalform und/oder einer bestimmten Modulation im Eingangssignals (*s_{EIN}*(*t*)) und/oder im Ausgangssignal (*s_{AUS}*(*t*)) ist.

7. Verfahren nach einem der Ansprüche 2 bis 4,
**dadurch gekennzeichnet,**
**dass** das Ereignis ein bestimmter Energiepegel oder Signal-Rausch-Abstand in einem oder mehreren Unterfrequenzbereichen des zum Eingangssignal (*s_{EIN}*(*t*)) gehörigen Spektrogramms ist.

8. Verfahren nach einem der Ansprüche 1 bis 7,
**dadurch gekennzeichnet,**
**dass** der Ermittlung des Ausgangssignals (*s_{AUS}*(*t*)) ein Überprüfen vorausgeht, ob das zu ermittelnde Ausgangssignal (*s_{AUS}*(*t*)) ein physikalisch und/oder systemtheoretisch korrektes Signal darstellt.

9. Vorrichtung zur Generierung eines gegenüber einem Eingangssignal (*s_{EIN}*(*t*)) im Zeitbereich und gleichzeitig im Frequenzbereich reduzierten zwischengespeicherten Ausgangssignals (*s_{AUS}*(*t*)) mit einer Analysefilterbank (1) zur Erzeugung eines zu einem Eingangssignal (*s_{EIN}*(*t*)) gehörigen Spektrogramms in einem bestimmten Zeit-Frequenz-Bereich, einer Selektions-Einheit (6) zur Selektion des Spektrogramms in mindestens einem Unterfrequenzbereich und/oder Unterzeitbereich des Zeit-Frequenz-Bereichs und zum Nicht-Weiterberücksichtigen der übrigen Unterfrequenzbereiche und/oder Unterzeitbereiche des Zeit-Frequenz-Bereichs und einer Synthesefilterbank (7) zur Erzeugung eines zu den Spektrogrammen einzig in allen selektierten Unterfrequenzbereichen und/oder Unterzeitbereichen gehörigen Ausgangssignals (*s_{AUS}*(*t*)), wobei für die Selektion der Unterfrequenzbereiche und/oder der Unterzeitbereiche Ereignisse im Spektrum des Eingangssignals (*s_{EIN}*(*t*)) und/oder im Zeitbereich des Eingangssignals (*s_{EIN}*(*t*)) und/oder des Ausgangssignals (*s_{AUS}*(*t*)) durch eine Detektions-Einheit (2) zu detektieren sind,
durch gekennzeichnet,
dass der Detektionseinheit (2) eine Kontroll-Einheit (4) nachgeschaltet ist, so dass durch eine von der Kontroll-Einheit (4) gesteuerte modifizierte Selektion von Unterfrequenzbereichen und/oder von Unterzeitbereichen im Ausgangssignal (*s_{AUS}*(*t*)) mittels zu generierender Selektierungssignale in Abhängigkeit der detektierten Ereignisse zusätzlich das Reziprozitätsgesetz der Nachrichtentechnik und das Nyquist-Kriterium erfüllt sind.

10. Vorrichtung nach Anspruch 9,
**dadurch gekennzeichnet,**
**dass** der Selektions-Einheit (6) zur Selektion eine Detektions-Einheit (2) zur Detektion von Ereignissen im Spektrogramm des Eingangssignals (*s_{EIN}*(*t*)) und/oder im Zeitverlauf des Eingangssignals (*s_{EIN}*(*t*)) und/oder des Ausgangssignals (*s_{AUS}*(*t*)) und eine Generator-Einheit (5) zur Generierung von Selektionssignalen anhand der detektierten Ereignisse und/oder anhand extern generierter Ereignisse vorgeschaltet sind.

11. Vorrichtung nach Anspruch 9 oder 10,
**dadurch gekennzeichnet,**
**dass** der Detektions-Einheit (2) eine logische Verknüpfungs-Einheit (3) zur logischen Verknüpfung der detektierten Ereignisse und/oder der extern generierten Ereignisse und eine Kontroll-Einheit (4) zur Überprüfung der physikalischen und/oder systemtheoretischen Korrektheit der aus den selektierten Unterfrequenzbereichen und/oder Unterzeitbereichen des Spektrogramms des Eingangssignals (*s_{EIN}*(*t*)) gewonnenen Ausgangssignals (*s_{AUS}*(*t*)) nachgeschaltet ist.

12. Vorrichtung nach einem der Ansprüche 9 bis 11,
**dadurch gekennzeichnet,**
**dass** die Analysefilterbank (1) aus mehreren einzelnen parallel arbeitenden Analysefiltern besteht, die das zum Eingangssignal (*s_{EIN}*(*t*)) gehörige Spektrogramm in jeweils nebengeordneten, sich über die Zeit erstreckenden Frequenzunterbereichen ermitteln.

13. Vorrichtung nach einem der Ansprüche 9 bis 12,
**dadurch gekennzeichnet,**
**dass** die Analysefilterbank (1) ein Fourier-Transformator ist und die Synthesefilterbank (7) ein inverser Fourier-Transformator ist.

## Claims

1. Method for generating a temporarily stored output signal *(S_{AUS}(t))* which is reduced both in the time range and in the frequency range compared with an input signal (S*_{EIN}*(*t*)), with the following steps:
- determination of a spectrogram of the input signal (S*_{EIN}*(*t*)) in a specific time-frequency range,
- selection of the spectrogram of the input signal *(S_{EIN}(t))* in at least one sub-frequency range and/or sub-time range of the time-frequency range and disregarding of the remaining sub-frequency ranges and /or sub-time ranges of the time-frequency range,
- determination of the output signal *(S_{AUS}(t))* solely from the selected spectrogram, wherein for the selection of the sub-frequency ranges and/or the sub-time ranges events are detected in the spectrum of the input signal *(S_{EIN}(t))* and/or in the time range of the input signal *(S_{EIN}(t))* and/or of the output signal *(S_{AUS}(t)),*
**characterised in that**
the selection of the sub-frequency ranges and/or the sub-time ranges is modified by means of selection signals to be generated depending on the detected events so that the reciprocity theorem of communications engineering and the Nyquist criterion are additionally satisfied for the determined output signals *(S_{AUS}(t)).*

2. Method according to claim 1,
**characterised in that**
the selection of at least one sub-frequency range and/or sub-time range in the spectrogram of the input signal *(S_{EIN}(t))* is made on the basis of at least one previously established event in individual time-frequency grid points of the input signal *(S_{EIN}(t)).*

3. Method according to claim 1 or 2,
**characterised in that**
the selection of at least one sub-frequency range and/or sub-time range in the spectrogram of the input signal *(S_{ElN}(t))* is made on the basis of at least one previously established event in individual time grid points of the input signal *(S_{EIN}(t))* and/or of the output signal *(S_{AUS}(t)).*

4. Method according to one of claims 1 to 3,
**characterised in that**
the selection of at least one sub-frequency range and/or sub-time range in the spectrogram of the input signal *(S_{ElN}(t))* is made on the basis of an event which occurred externally.

5. Method according to one of claims 2 to 4,
**characterised in that**
the event is a periodicity in the input signal (*S_{EIN}(t)*) and/or in the output signal *(S_{AUS}(t)*).

6. Method according to one of claims 2 to 4,
**characterised in that**
the event is the presence of a specific signal form and/or a specific modulation in the input signal (S*_{EIN}(t)*) and/or in the output signal (*S_{AUS}(t)*).

7. Method according to one of claims 2 to 4,
**characterised in that**
the event is a specific energy level or signal to noise ratio in one or more sub-frequency ranges of the spectrogram belonging to the input signal (*S_{EIN}*(*t*))·

8. Method according to one of claims 1 to 7,
**characterised in that**
the determination of the output signal (*S_{AUS}(t)*) is preceded by a check to establish whether the output signal (*S_{AUS}(t)*) to be determined is a signal which is correct physically and/or system-theoretically.

9. Device for generating a temporarily stored output signal (*S_{AUS}(t)*) which is reduced both in the time range and in the frequency range compared with an input signal (*S_{EIN}(t)*), with
an analysing filter bank (1) for generating a spectrogram belonging to an input signal (*S_{EIN}(t)*) in a specific time-frequency range, a selection unit (6) for selection of the spectrogram in at least one sub-frequency range and/or sub-time range of the time-frequency range and for disregarding the remaining sub-frequency ranges and/or sub-time ranges of the time-frequency range, and a synthesising filter bank (7) for generating an output signal *(S_{AUS}(t))* belonging to the spectrograms solely in all the selected sub-frequency ranges and/or sub-time ranges, wherein for the selection of the sub-frequency ranges and/or the sub-time ranges events are to be detected in the spectrum of the input signal *(S_{EIN}(t))* and/or in the time range of the input signal (*S_{EIN}(t)*) and/or of the output signal (*S_{AUS}(t)*) by a detection unit (2),
**characterised in that**
the detection unit (2) is followed by a control unit (4) so that the reciprocity theorem of communications engineering and the Nyquist criterion are additionally satisfied by a modified selection of sub-frequency ranges and/or sub-time ranges in the output signal *(S_{AUS}(t))* controlled by the control unit (4) by means of selection signals to be generated depending on the detected events.

10. Device according to claim 9,
**characterised in that**
the selection unit (6) for selection is preceded by a detection unit (2) for detection of events in the spectrogram of the input signal *(S_{EIN}(t))* and/or in the time line of the input signal *(S_{EIN}(t))* and/or of the output signal *(S_{AUS}(t)),* and by a generator unit (5) for generation of selection signals according to the detected events and/or according to externally generated events.

11. Device according to claim 9 or 10,
**characterised in that**
the detection unit (2) is followed by a logic connecting unit (3) for logically connecting the detected events and/or the externally generated events and by a control unit (4) for checking the physical and/or system-theoretical correctness of the output signal (*S_{AUS}(t)*) obtained from the selected sub-frequency ranges and/or sub-time ranges of the spectrogram of the input signal (*S_{EIN}(t))*.

12. Device according to one of claims 9 to 11,
**characterised in that**
the analysing filter bank (1) consists of a plurality of individual analysing filters working in parallel which determine the spectrogram belonging to the input signal *(S_{EIN}(t))* in coordinated frequency sub-ranges extending over the time.

13. Device according to one of claims 9 to 12,
**characterised in that**
the analysing filter bank (1) is a Fourier transformer and the synthesising filter bank (7) is an inverse Fourier transformer.

## Revendications

1. Procédé pour générer un signal de sortie (s_{AUS}(t)) mis en mémoire tampon réduit par rapport à un signal d'entrée (s_{EIN}(t)) dans le domaine temporel et simultanément dans le domaine fréquentiel comportant les étapes de procédé suivantes :
• la détection d'un spectrogramme du signal d'entrée (s_{EIN}(t)) dans un domaine temporel-fréquentiel déterminé,
• la sélection du spectrogramme du signal d'entrée (s_{EIN}(t)) dans au moins un sous-domaine fréquentiel et/ou un sous-domaine temporel du domaine temporel-fréquentiel et la non reconsidération des autres sous-domaines fréquentiels et/ou sous-domaines temporels du domaine temporel-fréquentiel,
• la détection du signal de sortie (s_{AUS}(t)) uniquement à partir du spectrogramme sélectionné,
dans lequel, pour la sélection des sous-domaines fréquentiels et/ou des sous-domaines temporels, des événements sont détectés dans le spectre du signal d'entrée (s_{EIN}(t)) et/ou dans le domaine temporel du signal d'entrée (s_{EIN}(t)) et/ou du signal de sortie (s_{AUS}(t)),
**caractérisé en ce que**
la sélection des sous-domaines fréquentiels et/ou des sous-domaines temporels est modifiée par l'intermédiaire de signaux de sélection générés selon les événements détectés de telle sorte que, pour le signal de sortie (s_{AUS}(t)) détecté, le principe de réciprocité de la technique des télécommunications et le critère de Nyquist sont remplis.

2. Procédé selon la revendication 1, **caractérisé en ce que**
la sélection d'au moins un sous-domaine fréquentiel et/ou un sous-domaine temporel se produit dans le spectrogramme du signal d'entrée (s_{EIN}(t)) en fonction d'au moins un événement préalablement constaté dans des points de trame fréquentielle-temporelle différents du signal d'entrée (s_{EIN}(t)).

3. Procédé selon la revendication 1 ou 2, **caractérisé en ce que**
la sélection d'au moins un sous-domaine fréquentiel et/ou d'un sous-domaine temporel se produit dans le spectrogramme du signal d'entrée (s_{EIN}(t)) en fonction d'au moins un événement préalablement constaté dans des points de trame temporelle différents du signal d'entrée (s_{EIN}(t)) et/ou du signal de sortie (s_{AUS}(t)).

4. Procédé selon l'une des revendications 1 à 3, **caractérisé en ce que**
la sélection d'au moins un sous-domaine fréquentiel et/ou un sous-domaine temporel se produit dans le spectrogramme du signal d'entrée (s_{EIN}(t)) en fonction d'un événement se produisant extérieurement.

5. Procédé selon l'une des revendications 2 à 4, **caractérisé en ce que**
l'événement est une périodicité dans le signal d'entrée (s_{EIN}(t)) et/ou dans le signal de sortie (s_{AUS}(t)).

6. Procédé selon l'une des revendications 2 à 4, **caractérisé en ce que**
l'événement est l'existence d'une forme de signal déterminé et/ou d'une modulation déterminée dans le signal d'entrée (s_{EIN}(t)) et/ou dans le signal de sortie (s_{AUS}(t)).

7. Procédé selon l'une des revendications 2 à 4, **caractérisé en ce que**
l'événement est un niveau d'énergie déterminé ou un rapport signal-bruit dans un ou plusieurs sous-domaines fréquentiels du spectrogramme associé au signal d'entrée (s_{EIN}(t)).

8. Procédé selon l'une des revendications 1 à 7, **caractérisé en ce que**
une vérification découle de la détection du signal de sortie (s_{AUS}(t)), si le signal de sortie (s_{AUS}(t)) à détecter représente un signal correct physique et/ou systémique.

9. Dispositif pour générer un signal de sortie (s_{AUS}(t)) mis en mémoire tampon réduit par rapport à un signal d'entrée (s_{EIN}(t)) dans le domaine temporel et simultanément dans le domaine fréquentiel comportant un banc de filtres d'analyse (1) pour générer un spectrogramme associé à un signal d'entrée (s_{EIN}(t)) dans un domaine temporel-fréquentiel déterminé, une unité de sélection (6) pour la sélection du spectrogramme dans au moins un sous-domaine fréquentiel et/ou sous-domaine temporel du domaine temporel-fréquentiel et en vue de la non reconsidération des autres sous-domaines fréquentiels et/ou sous-domaines temporels du domaine temporel-fréquentiel et un banc de filtres de synthèse (7) pour générer un signal de sortie (s_{AUS}(t)) associé au spectrogramme uniquement dans tous les sous-domaines fréquentiels et/ou sous-domaines temporels sélectionnés,
dans lequel, pour la sélection des sous-domaines fréquentiels et/ou des sous-domaines temporels, des événements doivent être détectés dans le spectre du signal d'entrée (s_{EIN}(t)) et/ou dans le domaine temporel du signal d'entrée (s_{EIN}(t)) et/ou du signal de sortie (s_{AUS}(t)) par une unité de détection (2),
**caractérisé en ce que**
l'unité de détection (2) est montée en aval d'une unité de contrôle (4), de sorte que le principe de réciprocité de la technique des télécommunications et le critère de Nyquist sont remplis grâce à une sélection modifiée commandée par l'unité de contrôle (4) des sous-domaines fréquentiels et/ou des sous-domaines temporels dans le signal de sortie (s_{AUS}(t)) au moyen de signaux de sélection à générer en fonction des événements détectés en plus.

10. Dispositif selon la revendication 9, **caractérisé en ce que**
une unité de détection (2) est montée en amont de l'unité de sélection (6) en vue de la sélection pour détecter des événements dans le spectrogramme du signal d'entrée (s_{EIN}(t)) et/ou dans le temps du signal d'entrée (s_{EIN}(t)) et/ou du signal de sortie (s_{AUS}(t)) et une unité de générateur (5) est montée en amont en vue de la génération de signaux de sélection selon des événements détectés et/ou selon des événements générés à l'extérieur.

11. Dispositif selon la revendication 9 ou 10, **caractérisé en ce que**
l'unité de couplage logique (3) en vue du couplage logique des événements détectés et/ou des événements générés à l'extérieur est montée en aval de l'unité de détection (2) et une unité de contrôle (4) est montée en aval en vue de la vérification de la correction physique et/ou systémique du signal de sortie (s_{AUS}(t)) obtenu à partir des sous-domaines fréquentiels et/ou des sous-domaines temporels sélectionnés du spectrogramme du signal d'entrée (s_{EIN}(t)).

12. Dispositif selon l'une des revendications 9 à 11, **caractérisé en ce que**
le banc de filtres d'analyse (1) est constitué de plusieurs filtres d'analyse différents fonctionnant en parallèle, qui détectent le spectrogramme associé au signal d'entrée (s_{EIN}(t)) dans des sous-domaines fréquentiels ou placés les uns à côté des autres respectivement et s'étendant dans le temps.

13. Dispositif selon l'une des revendications 9 à 12, **caractérisé en ce que**
le banc de filtres d'analyse (1) est un transformateur de Fourier et le banc de filtres de synthèse (7) est un transformateur de Fourier inversé.
